# EUROPÄISCHE PATENTSCHRIFT

(11) **EP 2 793 275 B1**
(45) Veröffentlichungstag und Bekanntmachung des Hinweises auf die Patenterteilung: **08.04.2020**
(21) Anmeldenummer: 14164840.2
(22) Anmeldetag: 16.04.2014
(51) Int. Cl.: H01L 31/18, H01L 31/05

(54) **Aufbringen von Leitkleber auf Solarzellen**
Application of conductive adhesive on solar cells
Application d'adhésif conducteur sur des cellules solaires

(30) Priorität: 16.04.2013 DE 102013103837
(43) Veröffentlichungstag der Anmeldung: 22.10.2014
(73) Patentinhaber: teamtechnik Maschinen und Anlagen GmbH, 71691 Freiberg (DE)
(72) Erfinder: Riethmüller, Dipl.-Ing. Axel, 73630 Remshalden (DE); Fischer, Thomas, 74385 Pleidelsheim (DE)
(74) Vertreter: Witte, Weller & Partner Patentanwälte mbB

(56) Entgegenhaltungen:
- EP-A1- 1 873 844
- EP-A1- 2 169 725
- EP-B1- 0 992 341
- WO-A1-2008/038414
- WO-A1-2012/102076
- WO-A1-2012/102077
- WO-A2-2012/016103
- DE-A1-102006 007 447
- US-A1- 2008 121 266

## Beschreibung

Die vorliegende Erfindung betrifft eine Solarzellen-Verbindungsvorrichtung zum Fertigen von Solarzellen-Strings aus einzelnen kristallinen Solarzellen und elektrisch leitfähigen Verbindern, mit einem ersten Modul zum Zusammenführen von Solarzellen und Verbindern, einem sich an das erste Modul anschließenden zweiten Modul zum Verbinden der Verbinder mit den Solarzellen, und einem dritten Modul zum Transport der Solarzellen vom ersten Modul durch das zweite Modul. Die Erfindung betrifft darüber hinaus ein Verfahren zum Aufbringen von leitfähigen Verbindern auf kristallinen Solarzellen, um mehrere Solarzellen elektrisch zu einem Solarzellenverbund (Solarzellen-String) miteinander zu verbinden. Die Dokumente EP 1873844 A1 und DE 102006007447 A1 beschreiben Solarzellen-Verbindungsvorrichtung und Verfahren zum Aufbringen von leitfähigen Verbindern auf Solarzellen gemäß der Stand der Technik.

Die Anmelderin bietet sogenannte Stringer-Anlagen an, die die Herstellung von Solarzellen-Strings in einer Anlage ermöglichen. Hierfür werden auf ein Transportband einzelne Solarzellen und streifenförmige elektrisch leitfähige Verbinder aufgelegt, wobei ein oder mehrere streifenförmige Verbinder von einer Solarzelle zu einer benachbarten Solarzelle verlaufen, insbesondere von der Rückseite einer Solarzelle zu der Vorderseite der benachbarten Solarzelle und umgekehrt oder von der Rückseite der einen Zelle zur Rückseite der nächsten Zelle. Diese Einheit aus Solarzellen und elektrisch leitfähigen Verbindern wird über das Transportband durch eine Lötstation gefahren, wobei in dieser Lötstation die elektrische und mechanische Verbindung der streifenförmigen Verbinder mit den jeweiligen Solarzellen erfolgt. Das Ergebnis ist am Ende eine Einheit aus mechanisch und elektrisch miteinander verbundenen in einer Reihe liegenden Solarzellen, die als Solarzellen-String bezeichnet werden.

Es versteht sich, dass innerhalb einer solchen Stringer-Anlage weitere Prozess- bzw. Verfahrensschritte vorgenommen werden, die an dieser Stelle jedoch nicht weiter ausgeführt werden sollen.

Obgleich sich diese Stringer-Anlagen in der Praxis bewährt haben und hohe Durchsätze ermöglichen, bleibt der Wunsch bestehen, weitere Verbesserungen vorzusehen, die einerseits die Flexibilität und Anpassbarkeit an unterschiedliche Solarzellentypen ermöglichen und andererseits auch Fehlerraten reduzieren, ohne die Prozeßsicherheit zu gefährden.

Vor diesem Hintergrund besteht die Aufgabe der vorliegenden Erfindung darin, eine Solarzellen-Verbindungsvorrichtung der eingangs genannten Art so weiterzubilden, dass die Flexibilität hinsichtlich neuer Technologien ermöglicht die Fehlerrate reduziert und die Prozeßsicherheit gewährleistet wird. Der Gegenstand der Erfindung ist in Ansprüche 1 und 6 definiert.

Diese Aufgabe wird bei der genannten Solarzellen-Verbindungsvorrichtung für kristalline Solarzellen dadurch gelöst, dass ein weiteres Modul bereitgestellt wird, dass vor dem ersten Modul vorgesehen ist und eine Siebdruckeinheit aufweist, um auf zumindest einer Seite einer Solarzelle ein leitfähiges Klebemittel aufzubringen.

Das heißt mit anderen Worten, dass ein weiterer Prozess in die Solarzellen-Verbindungsvorrichtung eingefügt wird, der die Flexibilität weiter erhöht. Das Aufbringen eines leitfähigen Klebemittels durch Siebdruck auf Bereiche der Solarzelle ermöglicht es, auf das übliche Verlöten zu verzichten. Dadurch können unter anderem auch weitere neuartige Solarzellentypen verarbeitet werden. Darüber hinaus können durch die Nutzung eines elektrisch leitfähigen Klebemittels geringere Prozesstemperaturen realisiert werden, was eine Reduzierung der Fehlerrate nach sich zieht. Insbesondere reduzieren sich die mechanischen Spannungen und es entstehen weniger Mikrorisse, was insbesondere auch die Langzeitstabilität gegenüber verlöteten Verbindungen erhöht. Das Aufbringen des Klebemittels durch ein Siebdruckverfahren ermöglicht einerseits eine sehr hohe Positioniergenauigkeit des Auftrags und andererseits eine hohe Prozeßsicherheit aufgrund der hohen Reproduzierbarkeit des Siebdrucks,

Die Integration eines solchen Prozesses in eine Solarzellen-Verbindungsvorrichtung, d.h. in eine Stringer-Anlage, liefert weitere Vorteile, die beispielsweise in der Einsparung von Steuerungskomponenten, einer Verringerung der Anzahl an Handlingschritten sowie beispielsweise in der Einsparung an Bildverarbeitungssystemen zur Lageerkennung und Ausrichtung der zu verarbeitenden Solarzellen zu sehen sind.

Bei einer bevorzugten Weiterbildung weist das zweite Modul eine Aushärteeinheit auf.

Dies hat den Vorteil, dass die Aushärtung des Klebemittels und damit insbesondere auch die mechanische Stabilität schneller erreicht wird, so dass es insgesamt auch eine Steigerung des Durchsatzes möglich wird.

Bei einer bevorzugten Weiterbildung weist das weitere Modul eine Handhabungseinrichtung auf, die ausgelegt ist, eine Solarzelle zu wenden. Weiter bevorzugt weist das weitere Modul einen Rundtisch auf, der Solarzellen für das Auftragen von Klebemittel in Aufnahmebereichen aufnimmt. Weiter bevorzugt weist der Rundtisch Aussparungen innerhalb der Aufnahmebereiche auf, die an Stellen vorgesehen sind, die mit den Auftragsbereichen übereinstimmen. Die Aussparungen sind bspw. als durchgehende Öffnungen ohne Boden oder als Vertiefungen mit Boden vorgesehen.

Diese Maßnahmen haben sich als besonders vorteilhaft herausgestellt, insbesondere im Hinblick auf einen schnellen und effizienten Prozessablauf innerhalb des weiteren Moduls.

Die der Erfindung zugrundeliegende Aufgabe wird auch durch ein Verfahren zum Aufbringen von leitfähigen Verbindern auf kristalline Solarzellen, um mehrere Solarzellen elektrisch zu einem Solarzellen-String miteinander zu verbinden, durch folgende Schritte gelöst:
- Bereitstellen einer kristallinen Solarzelle;
- Bereitstellen von elektrisch leitfähigen Verbindern;
- Auftragen durch Siebdruck eines elektrisch leitfähigen Klebemittels auf vorbestimmte Bereiche der Solarzelle;
- Verbinden der leitfähigen Verbinder mit Solarzellen an den vorbestimmten Bereichen, und
- Aushärten des Klebemittels zur elektrischen und mechanischen Verbindung von Verbindern mit Solarzellen.

Weiter bevorzugt umfasst der Schritt des Auftragens folgende Schritte:
- Auftragen des Klebemittels auf einer Seite einer Solarzelle, Wenden der Solarzelle und Auftragen des Klebemittels auf der anderen gegenüberliegenden Seite der Solarzelle.

Weiter bevorzugt erfolgt das Auftragen für mehrere Solarzellen gleichzeitig. Vorzugsweise erfolgt der Auftrag streifenförmig auf die Bereiche, wobei die Breite der Streifen an die Breite der Verbinder angepasst ist.

Weiter bevorzugt umfassen die vorbestimmten Bereiche der Solarzelle und/oder der Verbinder zumindest Teile der Flächen, die miteinander in Kontakt kommen.

Die Vorteile dieses erfindungsgemäßen Verfahrens wurden im Zusammenhang mit der erfindungsgemäßen Solarzellen-Verbindungsvorrichtung bereits erläutert, so dass darauf Bezug genommen wird.

Insgesamt zeigt sich, dass der Einsatz eines elektrisch leitfähigen Klebemittels zur Verbindung von Solarzellen über elektrisch leitfähige Verbinder und die Integration dieses Prozesses in eine Stringer-Anlage zu deutlichen Vorteilen führt, insbesondere im Hinblick auf Flexibilität und Kosten.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Weitere Vorteile und Ausgestaltungen der Erfindung ergeben sich aus der Beschreibung und der beiliegenden Zeichnung. Dabei zeigen:
- Fig. 1: eine schematische Darstellung einer erfindungsgemäßen Solarzellen-Verbindungsvorrichtung;
- Fig. 2: eine schematische Darstellung eines aus drei Solarzellen bestehenden Solarzellen-Strings in Draufsicht und Seitenansicht; und
- Fig. 3a bis d: schematische Darstellungen weiterer Arten von Solarzellen-Strings.

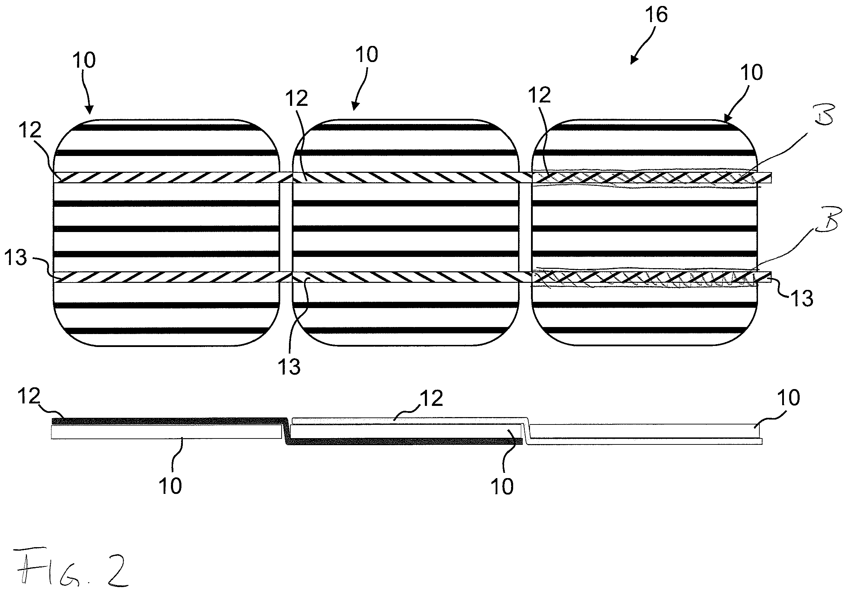

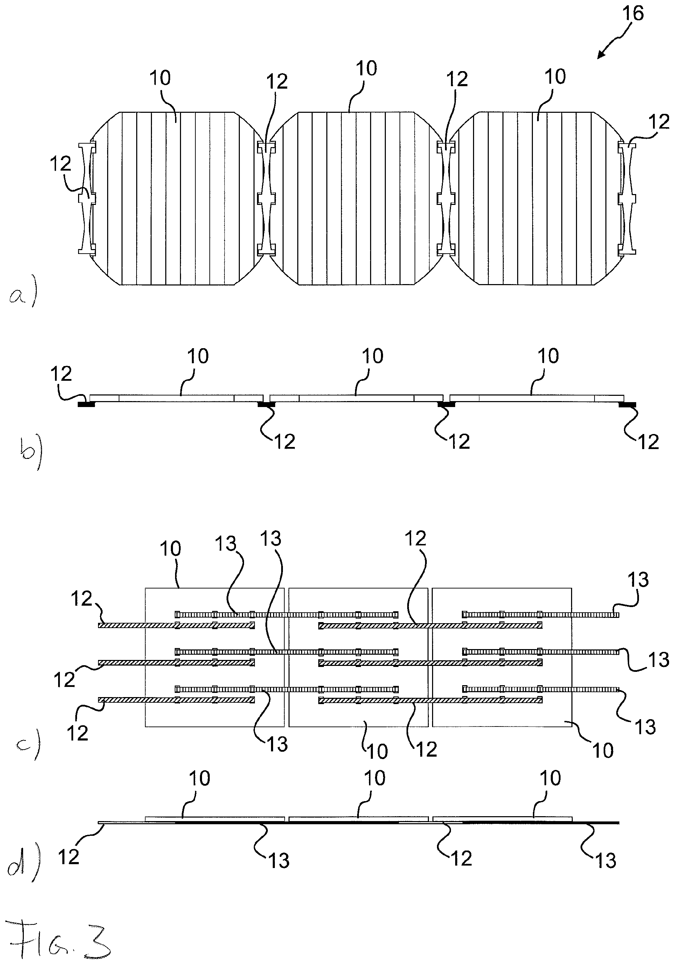

In Fig. 2 ist ein Ausschnitt eines Solarzellenstrings dargestellt und mit dem Bezugszeichen 16 gekennzeichnet. Dieser String 16 besteht aus mehreren kristallinen Solarzellen 10, die jeweils ein Kontaktgrid aus einzelnen dünnen elektrischen Leitungen besitzen. Senkrecht zu diesem Kontaktgrid verlaufen elektrisch leitfähige Streifen 12, 13, die mit dem Kontaktgrid verbunden sind, um eine elektrische Verbindung herzustellen. Diese Streifen 12, 13 können sich über die gesamte Länge einer Solarzelle und über die Länge der nächsten benachbarten Solarzelle erstrecken, wobei die Streifen dann, wie in Fig. 2 gut zu erkennen ist, auf die gegenüberliegende Seite (Unterseite) der Solarzelle gehen. Die Streifen 12, 13 verbinden folglich die Oberseite einer Solarzelle 10 mit der Unterseite der benachbarten Solarzelle. An dieser Stelle sei angemerkt, dass obgleich in Fig. 2 zwei Streifen 12, 13 gezeigt sind, auch mehr als zwei Streifen vorgesehen sein können. Des Weiteren gibt es Solarzellen, wie in Fig. 3a, b dargestellt, bei denen je ein Streifen quer über die Breite von zwei benachbarten Solarzellen verläuft und dadurch Vorläufer- und Nachfolgerzellen entsprechender Polung miteinander verbindet.

Bei dem Solarzellentyp, der in Fig. 3c und d gezeigt ist, erstrecken sich Streifen ebenfalls in Längsrichtung benachbarter Solarzellen ineinander geschachtelt. Die Streifen (beispielsweise fünf Stück) verbinden eine Rückseite mit der Rückseite von benachbarten Zellen. Da sich bei den in Fig. 3a bis d gezeigten Anordnungen die Streifen nur auf der Rückseite der Solarzellen befinden, spricht man in diesen Fällen von Rückseitenkontaktzellen.

Die vorbeschriebenen Verbindungen mit Hilfe von elektrisch leitfähigen Streifen werden dann für die gesamte Reihe von kristallinen Solarzellen wiederholt, so dass am Ende ein aus einer Vielzahl von einzelnen Solarzellen aufgebauter Solarzellen-String 16 entsteht, wobei die elektrische Verbindung der einzelnen Solarzellen über die Streifen 12, 13 erfolgt. Mit dem Begriff "Streifen" wird stellvertretend im weiteren ein elektrisch leitfähiger Verbinder bezeichnet, der von einer reinen Streifenform (z.B. in der Fig. 2 und Fig. 3c, d) bis zu konturangepassten Geometrien (z.B. Fig. 3a, b) reichen kann.

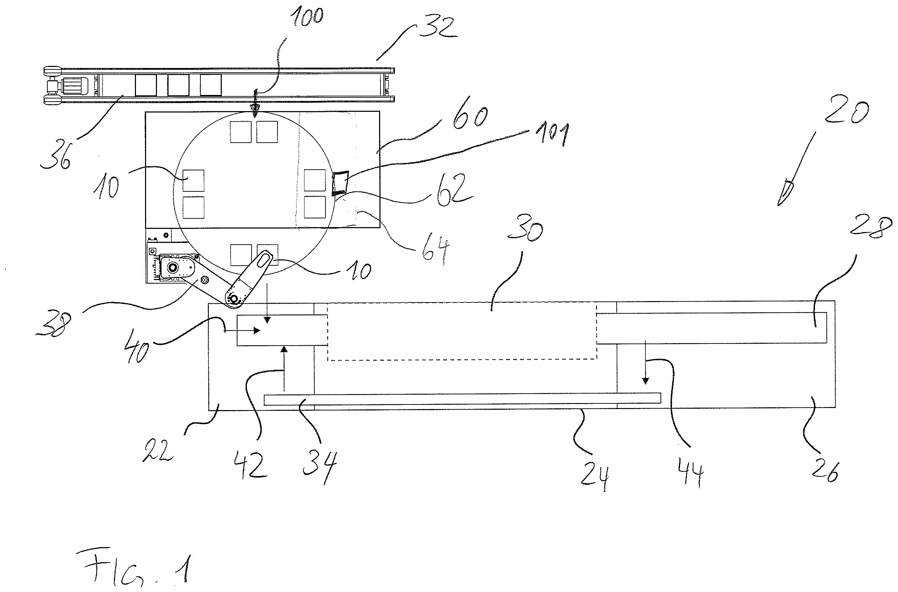

Die Herstellung solcher Solarzellen-Strings 16 erfolgt mit einer Solarzellen-Verbindungsvorrichtung, die in Fig. 1 schematisch als Blockdiagramm dargestellt und mit dem Bezugszeichen 20 gekennzeichnet ist. Diese schematische Darstellung dient der allgemeinen Erläuterung der Funktionsweise einer solchen Solarzellen-Verbindungsvorrichtung und zeigt aufgrund dessen keine technischen Details. Allgemein wird eine solche Solarzellen-Verbindungsvorrichtung 20 auch kurz als Stringer bzw. als Stringer-Anlage bezeichnet. Nachfolgend wird die Solarzellen-Verbindungsvorrichtung deshalb kurz als Stringer 20 bezeichnet.

Der in Fig. 1 gezeigte Stringer ist dazu ausgelegt, unterschiedlichste Typen von kristallinen Solarzellen zu verarbeiten, insbesondere die in den Fig. 2 und 3 gezeigten Solarzellen.

Der in Fig. 1 gezeigte Stringer 20 umfasst mehrere Module, welche die notwendigen Prozessschritte nacheinander ausführen. Zwischen diesen Prozessschritten können selbstverständlich noch Produkt- oder kundenspezifische Prozess-Zwischenschritte eingefügt werden. Diese Prozess-Zwischenschritte können einem der unten genannten Module zugeordnet sein, oder ein eigenständiges neues Modul bilden.

Der Stringer 20 umfasst ein erstes Modul bzw. Auflegemodul 22, das dazu dient, Solarzellen 10 und Streifen 12, 13 in richtiger Position zueinander aufzulegen.

Dem Auflegemodul 22 folgt direkt im Anschluss oder nach Prozesszwischenschritten ein zweites Modul 24, das beispielsweise eine Aushärteeinheit 30 aufweist. Schließlich folgt dem zweiten Modul 24 ein viertes Modul bzw. Nachbearbeitungs-Modul 26, in dem beispielsweise Prüfverfahren zur Prüfung der gefertigten Solarzellen-Strings 16 ausgeführt werden, oder beispielsweise die Strings auf eine Glasplatte aufgelegt werden.

Den erwähnten Modulen 22, 24, 26 ist ein drittes Modul bzw. Transportmodul 28 zugeordnet, das zumindest ein Transportband aufweist, welches vom ersten Modul 22 bis zum vierten Modul 26 verläuft und die Solarzellen vorzugsweise zusammen mit sogenannten Niederhalterelemente transportiert.

Des Weiteren ist in Fig. 1 ein fünftes Modul bzw. Magazin-Modul 32 gezeigt, das dem ersten Modul vorgelagert ist und eine Magazintransporteinheit 36 und eine Zellenbewegungs- und Positioniereinrichtung 100, z.B. ein Handhabungsgerät oder einen Roboter, umfasst. Das Magazin-Modul dient zur Bereithaltung von einzelnen Solarzellen 10 in Magazinen, die über die Magazintransporteinheit 36 in den Handhabungsbereich der Zellenbewegungs- und Positioniereinrichtung 100 gebracht werden. Die Zellenbewegungs- und Positioniereinrichtung 100 nimmt aus diesem Magazin nacheinander die einzelnen Solarzellen und legt sie entweder auf das Transportband im Bereich des Auflege-Moduls 22 oder bringt sie in ein sechstes Modul 60, in dem ein noch zu erläuternder Prozessschritt ausgeführt wird.

Zum Zuführen der Streifen 12, 13 ist dem ersten Modul 22 eine Streifenzuführeinheit 40 zugeordnet.

Schließlich weist der Stringer 20 in Fig. 1 noch eine Rücktransporteinheit 34 auf, die die Niederhalteelemente vom vierten Modul 26 zurück zum ersten Modul 22 transportiert. Bei einem solchen Niederhalteelement handelt es sich um eine Baugruppe, die auf eine Solarzelle und die aufgelegten Streifen aufgesetzt wird und die Streifen während des Transports fixiert.

Das sechste Modul 60 ist dem ersten Modul 22 vorgelagert und umfasst einen Rundtisch 62, der mehrere Solarzellen 10 aufnehmen kann, sowie einen Roboter 38 zum Handling von Solarzellen. Ferner weist das sechste Modul 60 eine Siebdruckeinheit 64 auf, deren Aufgabe darin besteht, ein elektrisch leitfähiges Klebemittel, nachfolgend als Leitkleber bezeichnet, an vorbestimmten Bereichen der Solarzelle aufzutragen. Bei den mit Leitkleber zu versehenden Bereichen handelt es sich um jene, auf die die Streifen 12, 13 aufgebracht werden sollen.

Die zu bedruckenden Solarzellen werden über den Rundtisch 62 in die Siebdruckeinheit 64 transportiert und dann nach dem Auftragen des Leitklebers aus der Siebdruckeinheit 64 austransportiert und in Richtung des ersten Moduls 22 transportiert. Die Zellenbewegungs- und Positioniereinrichtung 100 übernimmt dabei die Bestückung des Rundtisches 62 mit unbedruckten Solarzellen von der Magazintransporteinheit 36. Die Entnahme von bedruckten Solarzellen vom Rundtisch 62, um diese zum ersten Modul 22 zu führen übernimmt der Roboter 38.

Handelt es sich bei den Solarzellen 10 um solche, wie in Fig. 2 gezeigt, ist der Leitkleber auf beiden Seiten der Solarzelle aufzutragen. Dieses beidseitige Bedrucken einer Solarzelle lässt sich beispielsweise dadurch erreichen, dass eine Solarzelle zweimal die Siebdruckeinheit 64 durchläuft, wobei sie beispielsweise über den Roboter 38 oder eine Wendevorrichtung 101 dazwischen einmal gewendet wird.

Bei der in Fig. 1 gezeigten Ausgestaltung des Rundtisches 62 sind jeweils zwei Solarzellen an vier unterschiedlichen Positionen aufnehmbar. Das bedeutet, dass in einer Position eine Solarzelle mit ihrer Vorderseite und eine mit ihrer Rückseite aufgelegt sein kann. In der Siebdruckeinheit 64 lässt sich dann in einem Vorgang die Vorderseite der einen und die Rückseite der anderen Solarzelle mit Leitkleber bedrucken. Beim Austransport wird dann eine Solarzelle vom Roboter 38 zum ersten Modul 22 transportiert und die andere Solarzelle wird gewendet und dann durch Weiterdrehen des Rundtisches zu einem späteren Zeitpunkt wieder in die Siebdruckeinheit 64 transportiert. Um den aufgetragenen Leitkleber nicht zu beschädigen bzw. zu verwischen, sind im Rundtisch Vertiefungen vorgesehen, derart, dass der Leitkleber nicht mit dem Rundtisch in Kontakt kommt. Die bedruckte Solarzelle liegt folglich nur mit den nicht bedruckten Bereichen auf dem Rundtisch auf.

Sofern die Solarzellen jedoch nur auf einer Seite bedruckt werden müssen, ist ein Wenden nicht erforderlich und ein einziger Durchlauf durch die Siebdruckeinheit 64 genügt.

Durch die Integration des sechsten Moduls 60 mit der Siebdruckeinheit 64 ergibt sich ausgehend von dem Magazin-Modul 32 ein geschlossener kontinuierlicher Prozessablauf bis zum vierten Modul 26, wo der fertige Solarzellen-String entnommen werden kann.

Der Ablauf der einzelnen Prozessschritte, die von dem Stringer 20 ausgeführt werden, ist wie folgt:

Die Zellenbewegungs- und Positioniereinrichtung 100 entnimmt eine kristalline Solarzelle 10 von der Magazintransporteinheit 36 und legt sie in einer entsprechende Aufnahme im Rundtisch 62 ab. Diese Solarzelle 10 gelangt dann in die Siebdruckeinheit 64 und wird mit dem elektrisch leitfähigen Leitkleber an vorbestimmten Bereichen bedruckt. Bei diesen Bereichen, die in Fig. 2 mit B gekennzeichnet sind, handelt es sich um jene Flächen, auf die später Streifen 12, 13 aufgelegt werden.

Nach dem Bedrucken wird die Solarzelle aus der Siebdruckeinheit 64 austransportiert und dann vom Roboter 38 in das erste Modul 22 auf das Transportband des Transportmoduls 28 aufgelegt.

Über die Streifenzuführeinheit 40 werden dann die Streifen 12, 13 auf die mit Leitkleber versehenen Bereiche B aufgelegt, wobei anschließend ein Niederhalteelement über eine Handhabungseinrichtung 42 auf diese Einheit aus Solarzelle und Streifen aufgelegt wird.

Schrittweise wird dann diese Solarzelle mit den Streifen durch die Aushärteeinheit 30 transportiert, um beispielsweise durch Wärme den Leitkleber auszuhärten, so dass eine mechanisch stabile Verbindung zwischen Solarzelle und Streifen entsteht.

Im vierten Modul 26 wird das Niederhalteelement mit Hilfe einer weiteren Handhabungseinheit 44 abgehoben und der Rücktransporteinheit 34 zugeführt.

Bei dem genannten Leitkleber handelt es sich um ein Klebemittel, das beispielsweise Silberanteile enthält, um die elektrische Leitfähigkeit zu gewährleisten. Selbstverständlich sind auch andere Leitkleber mit anderen elektrisch leitfähigen Bestandteilen denkbar.

Darüber hinaus ist auch denkbar, dass das zweite Modul 24 neben der Aushärteeinheit 30 auch eine Löteinheit aufweist, so dass der Stringer 20 sowohl mit Leitkleber bedruckte Solarzellen als auch zu lötende Solarzellen verarbeiten kann.

## Patentansprüche

1. Solarzellen-Verbindungsvorrichtung zum Fertigen von Solarzellen-Strings aus
einzelnen kristallinen Solarzellen und elektrisch leitfähigen Verbindern, mit einem ersten Modul (22) zum Zusammenführen von Solarzellen (10) und Verbindern (12, 13);
einem sich an das erste Modul anschließenden zweiten Modul (24) zum Verbinden der Verbinder mit den Solarzellen;
einem dritten Modul (28) zum Transport der Solarzellen vom ersten Modul durch das zweite Modul,
**gekennzeichnet durch**
ein weiteres Modul (60), das vor dem ersten Modul vorgesehen ist und eine Siebdruckeinheit (64) aufweist, um auf zumindest eine Seite einer Solarzelle (10) ein leitfähiges Klebemittel aufzubringen, und
einer Handhabungseinrichtung (38), die ausgelegt ist, die mit dem leitfähigen Klebemittel versehene Solarzelle (10) in das erste Modul (22) und zum Transport durch das dritte Modul (28) zu führen.

2. Solarzellen-Verbindungsvorrichtung nach Anspruch 1, **dadurch gekennzeichnet, dass** das zweite Modul (24) eine Aushärteeinheit aufweist.

3. Solarzellen-Verbindungsvorrichtung nach einem der Ansprüche 1 bis 2, **dadurch gekennzeichnet, dass** die Handhabungseinrichtung (38; 101) ausgelegt ist, eine Solarzelle im weiteren Modul (60) zu wenden.

4. Solarzellen-Verbindungsvorrichtung nach einem der Ansprüche 1 bis 3, **dadurch gekennzeichnet, dass** das weitere Modul (60) einen Rundtisch (62) aufweist, der Solarzellen für das Auftragen von Klebemittel in Aufnahmebereichen aufnimmt.

5. Solarzellen-Verbindungsvorrichtung nach Anspruch 4, **dadurch gekennzeichnet, dass** der Rundtisch (62) Aussparungen innerhalb der Aufnahmebereiche aufweist, die an Stellen vorgesehen sind, die mit den Auftrags-Bereichen übereinstimmen.

6. Verfahren zum Aufbringen von leitfähigen Verbindern auf Solarzellen, um mehrere Solarzellen elektrisch zu einem Solarzellen-String miteinander zu verbinden, mit
a) Bereitstellen von elektrisch leitfähigen Verbindern in einem ersten Modul (22);
b) Bereitstellen einer kristallinen Solarzelle in einem weiteren Modul (60);
c) Auftragen durch Siebdruck eines elektrisch leitfähigen Klebemittels auf vorbestimmte Bereiche der Solarzelle,
d) Überführen der bedruckten einzelnen Solarzelle vom weiteren Modul (60) zum ersten Modul,
e) Verbinden der leitfähigen Verbinder mit Solarzellen an den vorbestimmten Bereichen im ersten Modul, und
f) Aushärten des Klebemittels zur elektrischen und mechanischen Verbindung von Verbindern mit Solarzellen in einem zweiten Modul (24),
wobei die Schritte a bis e kontinuierlich für mehrere Solarzellen zur Bildung eines Solarzellen-Strings ausgeführt werden.

7. Verfahren nach Anspruch 6, **dadurch gekennzeichnet, dass** der Schritt des Auftragens aufweist:
Auftragen des Klebemittels auf einer Seite einer Solarzelle,
Wenden der Solarzelle,
Auftragen des Klebemittels auf der anderen gegenüberliegenden Seite der Solarzelle.

8. Verfahren nach einem der Ansprüche 6 bis 7, **dadurch gekennzeichnet, dass** das Auftragen für mehrere Solarzellen gleichzeitig erfolgt.

9. Verfahren nach einem der Ansprüche 6 bis 8, **dadurch gekennzeichnet, dass** der Auftrag streifenförmig auf die Bereiche erfolgt, wobei die Breite der Streifen an die Breite der Verbinder angepasst ist.

10. Verfahren nach einem der Ansprüche 6 bis 9, **dadurch gekennzeichnet, dass** die vorbestimmten Bereiche der Solarzelle und/oder der Verbinder zumindest Teile der Flächen umfassen, die miteinander in Kontakt kommen.

## Claims

1. A solar cell connecting apparatus for manufacturing solar cell strings from individual crystalline solar cells and electrically conductive connectors, comprising
a first module (22) for bringing together solar cells (10) and connectors (12, 13);
a second module (24) adjoining the first module for connecting the connectors to the solar cells;
a third module (28) for transporting the solar cells from the first module through the second module,
**characterised by**
a further module (60) provided in front of the first module and having a screen printing unit (64) for applying a conductive adhesive to at least one side of a solar cell (10), and
a handling device (38) adapted to guide the solar cell (10) provided with the conductive adhesive into the first module (22) and for transport through the third module (28).

2. The solar cell connecting device according to claim 1, **characterized in that** the second module (24) comprises a curing unit.

3. The solar cell connecting device according to any one of claims 1 to 2, **characterized in that** the handling device (38; 101) is designed to turn a solar cell in the further module (60).

4. The solar cell connecting device according to any one of claims 1 to 3, **characterized in that** the further module (60) has a rotary table (62) which receives solar cells for the application of adhesive in receiving areas.

5. Solar cell connecting device according to claim 4, **characterized in that** the rotary table (62) has recesses within the receiving areas provided at positions corresponding to the application areas.

6. A method of applying conductive connectors to solar cells in order to electrically connect several solar cells to form a solar cell string, with
a) providing electrically conductive connectors in a first module (22);
b) providing a crystalline solar cell in another module (60);
c) application by screen printing of an electrically conductive adhesive onto predetermined areas of the solar cell,
d) transferring the printed individual solar cell from the further module (60) to the first module,
e) connecting the conductive connectors to solar cells at the predetermined areas in the first module; and
f) curing of the adhesive for electrical and mechanical connection of connectors to solar cells in a second module (24),
wherein the steps a) to e) are performed continuously for a plurality of solar cells to form a solar cell string.

7. The method according to claim 6, **characterized in that** the step of applying comprises
application of the adhesive on one side of a solar cell,
turning the solar cell,
apply the adhesive on the other opposite side of the solar cell.

8. The method according to any one of claims 6 to 7, **characterized in that** the application is carried out for several solar cells simultaneously.

9. The method according to any of claims 6 to 8, **characterized in that** the application is applied in strips to the areas, the width of the strips being adapted to the width of the connectors.

10. The method according to any one of claims 6 to 9, **characterized in that** the predetermined areas of the solar cell and/or the connectors comprise at least parts of the surfaces which come into contact with one another.

## Revendications

1. Dispositif de connexion de cellules solaires pour la préparation de chaînes de cellules solaires à partir de cellules solaires cristallines individuelles et de connecteurs électriquement conducteurs, comprenant un premier module (22) pour la réunion de cellules solaires (10) et des connecteurs (12, 13) ;
un deuxième module (24) suivant le premier module, pour la connexion des connecteurs avec les cellules solaires ;
un troisième module (28) pour le transport des cellules solaires depuis le premier module au travers du deuxième module,
**caractérisé par**
un module supplémentaire (60), qui est prévu avant le premier module et comprend une unité de sérigraphie (64), afin d'appliquer un adhésif conducteur sur au moins un côté d'une cellule solaire (10), et
un appareil de manipulation (38), qui est conçu pour conduire la cellule solaire (10) munie de l'adhésif conducteur dans le premier module (22) et pour le transport par le troisième module (28).

2. Dispositif de connexion de cellules solaires selon la revendication 1, **caractérisé en ce que** le deuxième module (24) comprend une unité de durcissement.

3. Dispositif de connexion de cellules solaires selon l'une quelconque des revendications 1 à 2, **caractérisé en ce que** l'appareil de manipulation (38 ; 101) est conçu pour retourner une cellule solaire dans le module supplémentaire (60).

4. Dispositif de connexion de cellules solaires selon l'une quelconque des revendications 1 à 3, **caractérisé en ce que** le module supplémentaire (60) comprend une table tournante (62), qui reçoit des cellules solaires dans des zones de réception pour l'application d'adhésif.

5. Dispositif de connexion de cellules solaires selon la revendication 4, **caractérisé en ce que** la table tournante (62) comprend des évidements à l'intérieur des zones de réception, qui sont prévus à des emplacements qui correspondent aux zones d'application.

6. Procédé d'application de connecteurs conducteurs sur des cellules solaires, afin de connecter électriquement plusieurs cellules solaires les unes avec les autres en une chaîne de cellules solaires, comprenant :
a) la préparation de connecteurs électriquement conducteurs dans un premier module (22) ;
b) la préparation d'une cellule solaire cristalline dans un module supplémentaire (60) ;
c) l'application par sérigraphie d'un adhésif électriquement conducteur sur des zones prédéterminées de la cellule solaire,
d) le transfert de la cellules solaire individuelle imprimée depuis le module supplémentaire (60) vers le premier module,
e) la connexion des connecteurs conducteurs avec des cellules solaires au niveau des zones prédéterminées dans le premier module, et
f) le durcissement de l'adhésif pour la connexion électrique et mécanique de connecteurs avec des cellules solaires dans un deuxième module (24),
les étapes a à e étant réalisées en continu pour plusieurs cellules solaires pour la formation d'une chaîne de cellules solaires.

7. Procédé selon la revendication 6, **caractérisé en ce que** l'étape d'application comprend :
l'application de l'adhésif sur un côté d'une cellule solaire,
le retournement de la cellule solaire,
l'application de l'adhésif sur l'autre côté opposé de la cellule solaire.

8. Procédé selon l'une quelconque des revendications 6 à 7, **caractérisé en ce que** l'application a lieu simultanément pour plusieurs cellules solaires.

9. Procédé selon l'une quelconque des revendications 6 à 8, **caractérisé en ce que** l'application a lieu en forme de bandes sur les zones, la largeur des bandes étant adaptée à la largeur des connecteurs.

10. Procédé selon l'une quelconque des revendications 6 à 9, **caractérisé en ce que** les zones prédéterminées de la cellule solaire et/ou des connecteurs comprennent au moins des parties des surfaces qui rentrent en contact les unes avec les autres.
